# EUROPEAN PATENT APPLICATION

(11) **EP 3 547 705 A1**
(43) Date of publication of application: **02.10.2019**
(21) Application number: 19165752.7
(22) Date of filing: 28.03.2019
(51) Int. Cl.: H04Q 9/00, H01M 10/42, G01R 31/36

(54) **FAULT-TOLERANT BATTERY MANAGEMENT**

(30) Priority: 28.03.2018 US 201862649481 P
(71) Applicant: Navitas Solutions, Inc., Hillsborough, NJ 08844 (US)
(72) Inventor: Lee, Jaesik, Basking Ridge, NJ 07920 (US); Lee, Inseop, Pittstown, NJ 08867 (US); Lee, Minkyu, Ringoes, NJ 08551 (US); Chon, Andrew M., Princeton, NJ 08540 (US)
(74) Representative: Dendorfer, Claus

(57) **Abstract**

Battery Management System (BMS) which includes a plurality of master battery management units (M-BMU), each comprising at least one multi cell battery sensing device. The multi cell battery sensing device configured to directly sense one or more conditions associated with each battery cell of a group of battery cells that are associated with one battery module. The BMS also includes a plurality of sensor battery management units (S-BMU) associated with each of the battery modules. Each S-BMU is a single-cell battery sensing device arranged to directly sense one or more conditions associated with a particular battery cell. Each S-BMU is configured to wirelessly communicate data acquired as a result of the direct sensing to an M-BMU associated with the particular battery module.

## Description

### BACKGROUND

### Cross-Reference to Related Applications

This application claims the benefit of U.S. Provisional Application No. 62/649,481 filed on March 28, 2018 which is hereby incorporated by reference in its entirety.

### Statement of the Technical Field

The technical field of this disclosure concerns battery management systems and more particularly concerns battery management systems that are fault tolerant.

### Description of the Related Art

Lithium-ion (Li-ion) batteries are growing in popularity as energy storage reservoirs for industrial and automotive applications, high-voltage energy uses (smart grid), such as wind turbines, photo-voltaic cells, and hybrid electric vehicles. Large-scale lithium-ion battery systems for hybrid/electric vehicles (xEV) or large-capacity energy storage systems (ESS) consist of a multiplicity of battery cells which are assembled together to form battery modules or battery packs. A large scale battery system can comprise many of these battery modules or battery packs.

The growing popularity of large scale lithium-ion battery systems has spurred demand for safer, higher performing battery monitoring and protection systems. Battery stacks using Li-Ion technology can comprise a large number of individual cells totaling hundreds of cells at different voltages. Each cell must be properly monitored and balanced to ensure user safety, improve battery performance and extend battery life. Therefore, the battery management system (BMS) is one of critical components for small and large-scaled battery applications.

The BMS monitors the voltage, the current, impedance, and the temperature of each cell. Since a BMS has to monitor each and every Li-Ion battery cell, it had been a common practice to wire the BMS to every Li-Ion cell. When the number of Li-Ion cells increases to a few hundred, or up to thousands, which is often the case for electric vehicle (EV) or power plant applications, the wire harness becomes a serious problem. Thus, one of the issues of BMS implementation is wiring. To avoid such problem some BMS systems have used wireless transceivers to facilitate communications between a sensor level node mounted on each battery cell that is wirelessly connected to master-level battery management unit.

### SUMMARY

This document concerns a BMS which includes several different types of monitoring nodes which function cooperatively to facilitate high reliability redundant sensing. The BMS will include a plurality of master battery management units (M-BMU). Each M-BMU will includes at least one multi cell battery sensing device. The multi cell battery sensing device in each M-BMU is configured to directly sense at least one condition of each battery cell of a group of battery cells that are associated with one battery module. As is known, a large scale battery pack can be comprised of many such battery modules.

The BMS also includes a plurality of sensor battery management units (S-BMU) associated with each of the battery modules. Each of the S-BMU comprise a single-cell battery sensing device and is configured to directly sense one or more conditions associated with a particular battery cell (e.g., voltage, current and/or temperature). Each of the S-BMU associated with a particular battery module is configured to wirelessly communicate data acquired as a result of the direct sensing by the individual S-BMU, to one of the plurality of M-BMU associated with the particular battery module.

In a solution described herein, the S-BMU and the M-BMU are configured to directly sense one or more the same conditions. Consequently, the data acquired as a result of the direct sensing by the M-BMU is redundant as compared to the data acquired as a result of the direct sensing by the S-BMU. In some scenarios, the M-BMU may be configured to compare for each battery cell the data acquired as a result of the direct sensing by the M-BMU and the data acquired as a result of the direct sensing by the S-BMU for that cell.

The M-BMU can also be configured to use the data provided by the plurality of S-BMU and/or the data directly acquired by the M-BMU, to evaluate a status of each battery cell associated with a particular battery module. For example, such evaluation can involve determining a battery state such as a state of charge (SoC) and/or a state of health (SoH). In such scenarios, the M-BMU may be configured to wirelessly communicate the SoC and/or SoH of each battery cell in a particular battery module, to a top-level battery management unit (T-BMU).

According to one aspect of a solution described herein, the M-BMU can be configured to communicate with the plurality of S-BMU in accordance with a first wireless communication protocol, and to communicates with the T-BMU in accordance with a second wireless communication protocol. In such a scenario, the first wireless communication protocol can advantageously be chosen so that it is different from the second wireless communication protocol. Further, each of the M-BMU can include a first wireless transceiver to facilitate the wireless communications with the plurality of S-BMU associated with a battery module, and a second wireless transceiver to facilitate the wireless communications with the T-BMU. Consequently, communications with the S-BMU can occur concurrently with the communications involving the T-BMU.

The M-BMU can communicate to a top-level battery management unit (T-BMU) one or more data types such as (a) raw data acquired as a result of the direct sensing by the M-BMU, (b) raw data acquired as a result of the direct sensing by the S-BMU, (c) SoC data determined for each battery cell associated with the battery module, and/or (d) SoH data determined for each battery cell associated with the battery module. Consequently the T-BMU can compare the SoC data and/or the SoH data provided by the M-BMU to independently determined SoC and/or SoH data estimated by the T-BMU. Such SoC/SoH data determined by the T-BMU can be based on the raw data acquired as a result of the direct sensing by the M-BMU and/or the raw data acquired as a result of the direct sensing by the S-BMU.

In the solution disclosed herein, the M-BMU is configured to facilitate the direct sensing of each battery cell of a particular battery module using a plurality of M-BMU wired connections which couple the M-BMU to the battery cell terminals of each battery cell. Further, each of the S-BMU is configured to facilitate the direct sensing of each battery cell using an S-BMU wired connection. The S-BMU wired connection is physically distinct from the M-BMU wired connection to facilitate an increase in a degree of redundant sensing.

From the foregoing it will be appreciated that an M-BMU in a BMS described herein will serve at least a dual purpose. The dual purpose will include a first purpose in which it functions as a multi cell battery sensing device to facilitate redundant sensing, and a second purpose in which the M-BMU functions as an intermediate level data collection node for a plurality a single-cell battery sensing devices. In some scenarios, the M-BMU can also be configured to serve a third purpose involving a battery cell balancing function.

Further reliability and battery system safety can be facilitated by configuring each M-BMU to comprise a plurality of the multi-cell sensing devices. In such a scenario, the plurality of multi-cell sensing devices are each configured to facilitate within the M-BMU an additional level of redundant direct sensing of the at least one condition. In other scenarios, an additional level of reliability and safety can be added by configuring the M-BMU to include a fault-tolerant multi-cell sensing system on a chip.

The solution also includes a method for redundantly sensing a plurality of batteries in a battery pack. The method involves using at least one multi cell battery sensing device in each of a plurality of M-BMU. The one or more multi cell battery sensing device(s) will directly sense at least one condition of each battery cell within a particular battery module of a battery pack. A plurality of S-BMU respectively individually sense directly at least one condition associated with each of a plurality of battery cells associated with each of the battery modules. The method further involves wirelessly communicating from each of the plurality of S-BMU of a particular battery module, to an M-BMU associated with the particular battery module, data acquired as a result of the individual direct sensing of each battery cell in the particular battery module.

### BRIEF DESCRIPTION OF THE DRAWINGS

This disclosure is facilitated by reference to the following drawing figures, in which like numerals represent like items throughout the figures, and in which:
FIG. 1 is the example of a circuit board-level redundant BMS topology;
FIG 2. is a drawing that is useful for understanding a fault-tolerant battery sensing system-on-a-chip (SOC) architecture;
FIG. 3 is drawing that is useful for understanding an architecture of a fault tolerant BMS;
FIG. 4 is a schematic diagram which is useful for understanding an implementation of the BMS architecture shown in FIG. 3.
FIG. 5 is a block diagram which is useful for understanding certain aspects of a sensor battery management unit;
FIGS. 6A and 6B are a series of drawings which are useful for understanding a distinction between a Sensor-In-Battery (SIB) and a Sensor-on-Battery (SOB) configuration for a battery sensor unit.
FIG. 7 is a schematic drawing which is useful for understanding an implementation of the BMS system shown in FIG. 4, where a master battery management unit serves a dual purpose to facilitate redundant battery cell sensing;
FIG. 8 is a schematic drawing which is useful for understanding an implementation of a BMS similar to the one shown FIG. 7, where the master battery management unit is comprised of a fault-tolerant battery sensing System-on-a-Chip (SoC);
FIG. 9 is a communication timing diagram which is useful for understanding how data is communicated in the BMS having the architecture shown in FIG. 4;
FIG. 10 is a schematic drawing which is useful for understanding an implementation of a BMS architecture shown in FIG. 4, where the master battery management unit includes dual wireless transceivers;
FIG. 11 is a communications timing diagram which is useful for understanding how data can be communicated in the BMS implementation shown in FIG. 10.

### DETAILED DESCRIPTION

It will be readily understood that the solution described herein and illustrated in the appended figures could involve a wide variety of different configurations. Thus, the following more detailed description, as represented in the figures, is not intended to limit the scope of the present disclosure, but is merely representative of certain implementations in various different scenarios. While the various aspects are presented in the drawings, the drawings are not necessarily drawn to scale unless specifically indicated.

Two known international industrial safety standards include: (1) IEC 61508 - entitled "Functional Safety of Electrical/Electronic/Programmable Electronic Safety-related Systems", and (2) ISO 26262, entitled "Road vehicles - Functional safety". IEC 61508 is published by the International Electrotechnical Commission (IEC) and is set forth as a basic functional safety standard to ensure the safety of any type of electronic or electrical system. ISO 26262 is an adaptation of IEC 61508 for Automotive Electric/Electronic Systems as set forth by the International Organization for Standardization (ISO). As such, ISO 26262 is intended for ensuring the functional safety of electrical and/or electronic systems in production automobiles.

Functional safety is defined in ISO 26262 as freedom from unacceptable risks, due to hazards caused by malfunctions of an electric/electronic system. Pursuant to the guidelines set forth in ISO 26262, it is mandatory that a component or a system is transferred to a safe state should a failure occur. Several additional criteria emphasized in ISO 26262 are that (1) a system must guard against any single point failure creating a hazard, (2) hazards must be detectable even in the event the primary monitor fails, (3) it is preferable that any redundant circuit is of a less complex design than the primary (4) the redundant components should be independent, and (5) the extent of diagnostic coverage of the components should match the hazard level.

A battery management system (BMS) fundamentally constitutes a safety component of a large-scale battery system. Properly handling such a complex battery system during its entire life cycle can be effectively achieved by utilizing the proper quality and safety management apparatus. In a solution presented herein, the broad safety goals outlined in IEC 61508 and ISO 26263 are effectively and economically achieved in a BMS.

One of the useful solutions disclosed herein involves introducing a degree of redundancy to sensing functionality in a BMS. Such redundancy can reduce the probability that one electronic failure will leave the battery and charging system in a state that allows, or even engenders, a significantly destructive cell mishap. More particularly, a BMS that can continue full, safe operation after any single unrepaired fault (and after most 2nd and third unrepaired faults) can be solved by a system with dually redundant battery sensing and management functional circuitry arranged in independent, fault isolated modules.

The solution disclosed herein is intended to counter the drawbacks of large-capacity battery systems and to satisfy well-known safety requirements. The solution satisfies safety standards without adding significant cost. The redundant sensing solution is: (1) able to issue an alarm for over-voltage (OV), under-voltage (UV) and over-temperature (OT) conditions (separate alarms for each condition are facilitated), (2) operate completely independently of the primary monitor (i.e., separate inputs, supplies, and references) to mitigate single point failures, and (3) provides diagnostics that can validate circuit and alarm operation. In addition to the foregoing, the redundant sensing solution is advantageously configured to comprise (4) a hardware only solution (to mitigate the dependence on software), and (5) the redundant system will work with most Li-ion chemistries available for mass production. A final key aspect of the solution is that it is (6) cost-effective. In this regard, the added cost of the redundant sensing solution will be only a fraction of the cost of the primary sensing system.

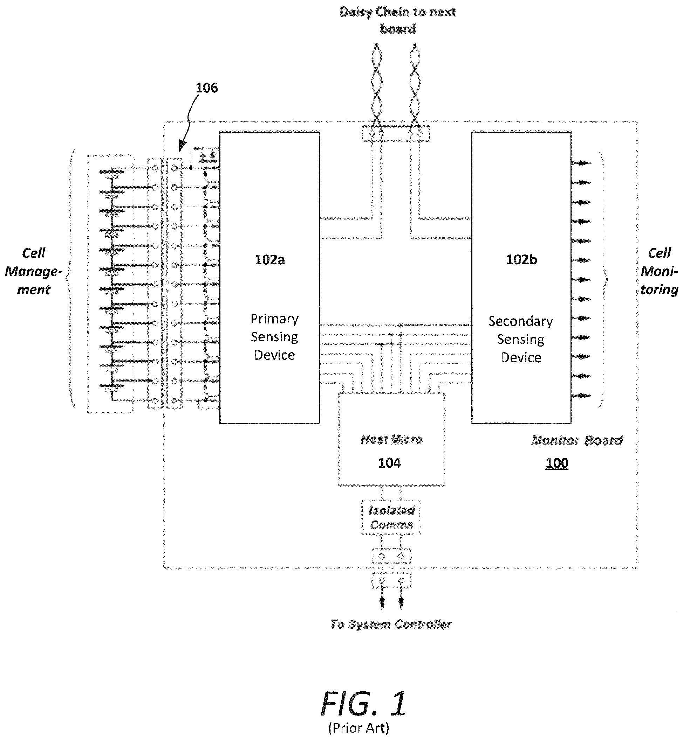

FIG. 1 illustrates a conventional circuit board-level redundant BMS solution which includes two independent, fault-isolated sensing devices 102a, 102b disposed on BMS monitor board 100. Both sensing devices 102a, 102b can operate under the control of a host microprocessor 104. In some scenarios, the sensing devices 102a, 102b can comprise two identical battery sensing devices. In other scenarios one of the sensing devices can be considered a primary sensing devices, and the other may be a back-up battery sensing device. In such a scenario, it is considered advantageous that the primary and back-up battery sensing device complement each other to collect the necessary information to manage the system, and to provide an additional independent safety mechanism.

A drawback of the configuration in FIG. 1 is that it can significantly increase the BMS cost by basically requiring the use of two battery sensing devices. Another drawback is that provision of only one set of cell inputs 106 on the battery sensing board, which must be shard as between the two sensing devices 102a, 102b. Such an arrangement does not allow the inputs of the redundant sensing device 102b to be completely isolated from the primary sensing device 102a. Of course, using two sensing devices also draws more current from the battery cell and this is another drawback of the conventional system that is shown.

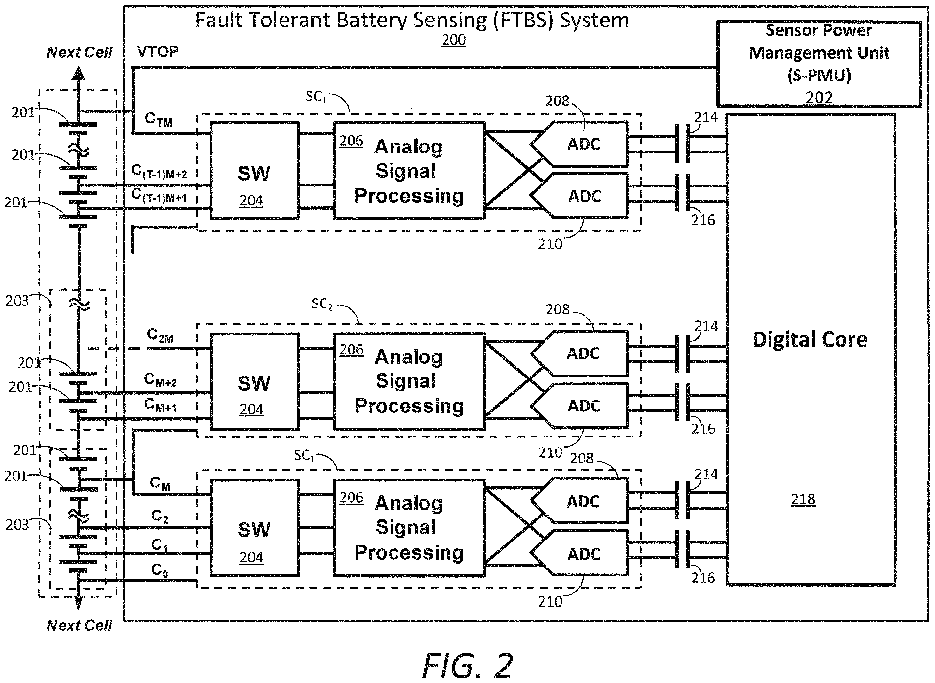

FIG. 2 shows a block diagram of a fault tolerant battery sensing system (FTBS) 200 in the form of a single sensing system-on-a-chip (SOC). In some scenarios the sensing device can also be comprised of a single package multi-chip-module (MCM). The FTBS 200 is disclosed in United States Patent Application No. 16/040,154 filed on July 19, 2018, which is incorporated herein by reference in its entirety.

The FTBS 200 includes a plurality of redundant cell monitoring or sensing components and a built-in multiple-step sensing validation test. More particularly, the FTBS system 200 is comprised of an *N*-cell battery sensor (where *N* is an integer value greater than 1). The *N*-cell battery sensor is comprised of a plurality of identical sensing channels SC₁, SC₂. . SC_{T}. Each sensing channel is responsible for voltage measurements of *M* battery cells 201 (where *M* is an integer value greater than 1). As such, each sensing channel includes a switching array 204, analog signal processing (ASP) circuitry 206, a main ADC 208 and a redundant ADC 210. The FTBS system further includes an isolated power management unit 202 with dual reference voltage generators, dual analog-to-digital converters, and a 'Sum of *M-*cell in a sensing channel' measurement circuitry (not shown in FIG. 2).

One or more of the sensing channels SC₁ SC₂. .SC_{T} is/are designated as backup or auxiliary sensing channels. These backup or auxiliary sensing channels are provided so that they can, if necessary, can take on the role of a sensing channel that develops a fault and therefore does not operate properly. Accordingly, a backup or auxiliary sensing channel can be understood to be one of the sensing channels SC₁, SC₂. .SC_{T} that is in excess of those that are needed by the FTBS system to perform battery sensing of the *N* cells.

A digital core 218 controls the measurement operations. The digital core 218 receives sensing data from a main ADC 208 and a redundant ADC 210 of each sensing channel. This sensing data is communicated to the digital core 218 through capacitive couplings 214, 216 and confirms the validation of sensory data. The capacitive couplings provide galvanic isolation between each sensing channel and the digital core unit. The galvanic isolation involves using differential high-voltage capacitors that capacitive couple digital-type AC signals from the digital core to the sensing channel, or vice versa while effectively sustaining high common-mode voltages.

In FIG. 2, each sensing channel is made up of *M* cell sensors for an *M-cell* channel battery string 203. The ratio of *N* to *M* can be an integer number (*N*/*M* = *T* = 1, 2, 3 or more), but not necessarily. For example, in a scenario in which a battery sensor is provided for sensing a 16-cell battery string, one sensing channel can handle 16 cells, 8 cells, 4 cells, 2 cells or 1 cell. The *N*/*M* ratio (*T*) can be determined depending on required measurement synchronization, measurement reliability, occupied silicon area, and so on. Sensing channels use a rank value to identify respective sensing channels. For example, in one scenario a sensing channel 1 (SC₁) can be provided with a rank "1", sensing channel 2 (SC₀) can be provided with a rank "2", and so on. It is noted that a lesser rank value indicates lower cells in the series. So, as an example, in FIG. 2 SC₁ processes the measurement of the *M* cells 201 that correspond to the lowest side battery terminal.

The solution shown in FIG. 2 can be cost-effective because it has a primary and redundant sensing device on a single Silicon integrated circuit chip. However, this single-chip type of redundant sensing scheme cannot separate the inputs of the primary and redundant sensors and must have a separate calibration algorithm so that the two sensors can be controlled and calibrated separately from each other.

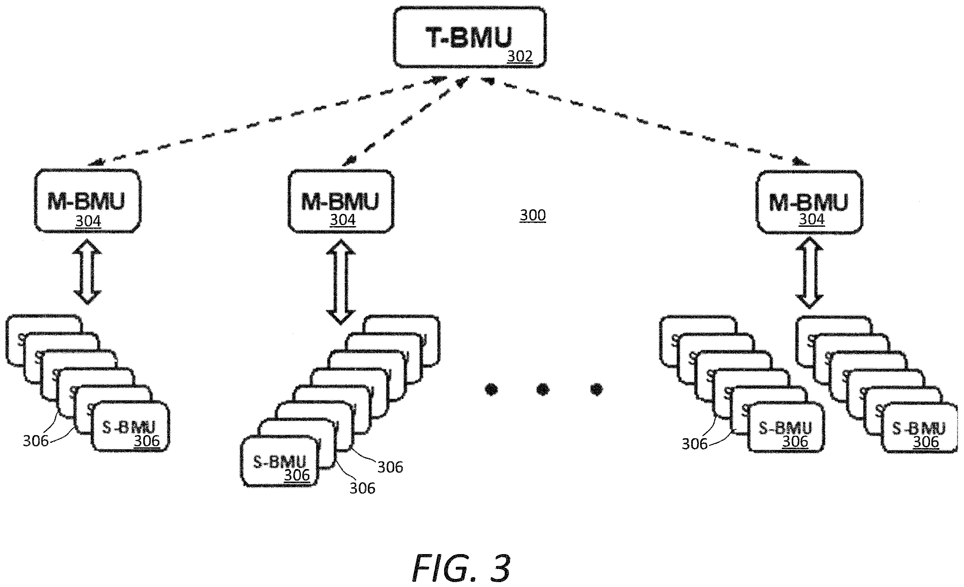

Shown in FIG. 3 is an architecture for a wireless battery area network (WiBaAN) 300 which is useful for understanding of a fault-tolerant battery management system. The WiBaAN 300 includes (1) a plurality of sensor battery management units (S-BMU) 306, (2) a plurality of master battery management units (M-BMU) 304, (3) and a top-level battery management unit (T-BMU) 302. These components comprise individual nodes of a WiBaAN which communicate in accordance with one or more wireless communication protocols and in accordance with a predetermined wireless network topology.

As explained below in greater detail, the WiBaAN in FIG. 3 can be configured for implementing a fault-tolerant battery management system within a large-scale battery pack comprised of a multiplicity of battery cells connected in series and/or parallel. The arrangement shown is based on a hierarchical star network and consists of three different levels of battery controllers: T-BMU, M-BMUs, and S-BMUs. The T-BMU controls the functions and operations of the M-BMUs within a large-scale battery pack and estimates the amount of charge and health of the cells through the data collected from the M-BMUs. The T-BMU can be configured to transmits final data concerning a battery pack to a higher level computer system (not shown). For example, the higher level computer system in the automotive context can comprise an automotive engine control unit. In such a scenario, the T-BMU can communicate with the higher level computer system using any suitable communication methodology, such as a Controller Area Network (CAN or CAN-bus).

In the system shown in FIG. 3, a first 1:*M* wireless communication network is established between a T-BMU and multiple (*M*) M-BMUs. The frequency spectrum, frequency channels, time slots, modulation types used for implementing such wireless communication network are not critical and will be determined by the WiBaAN protocol that is in use by the network. In a scenario shown in FIG. 3, each M-BMU can in some scenarios be arranged to manage one battery module (e.g., which may be comprised of a plurality of battery cells connected in series). The cell information of each battery module is transmitted from each M-BMU to the T-BMU based on a predetermined time schedule.

A second 1:S wireless communication network is formed between each M-BMU and a plurality (*S*) of S-BMUs in the lower level. A large-capacity battery pack for an electric vehicle is composed of a plurality of battery modules. One M-BMU and one of the second wireless networks can be provided for each battery module. Accordingly, in some scenarios the number of M-BMUs and the number of second wireless networks associated therewith can be determined by the number of battery modules in a large-capacity battery pack. From the foregoing it may be understood that a relatively large number of the second wireless networks may be present in a BMS which manages are large-capacity battery pack. Consequently, the second wireless networks can in some scenarios require the implementation of a WiBaAN protocol that minimizes communication interference between multiple second wireless networks. In addition, the wireless protocol used for such network is advantageously designed to minimize communication collisions and data loss between the first and second wireless networks. The higher node of the network architecture usually operates with a longer interval of control and execution time than its immediately lower layer.

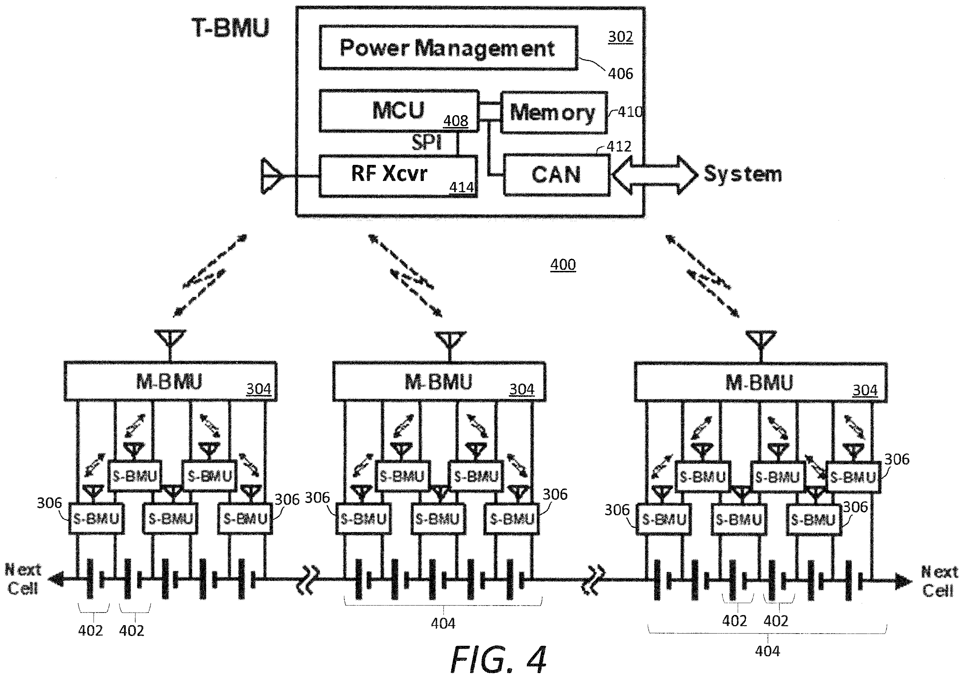

FIG. 4 is a drawing showing certain details of a WiBaAN network 400 implemented in accordance with the architecture of FIG. 3. As illustrated therein, the network consists of three different levels of battery monitoring and/or control nodes: T-BMU 302, M-BMUs 304, and S-BMUs 306. The T-BMU 302 can comprise several components including a power management unit 406, a master control unit (MCU) 408, a data store or memory 410 in communication with the MCU, a radio frequency transceiver 414, and a data interface 412 (e.g., a data interface compatible with a Controller Area Network, such as a CAN or CAN-bus). The MCU can comprise one or more components such as a microcontroller, an application specific circuit, a programmable logic device, or other type of electronic circuit programmed to perform the functions described herein. The radio frequency transceiver 414 can be any suitable radio transceiver operating under the control of the MCU to facilitate the wireless network communications described herein.

According to one aspect of a solution disclosed herein, each S-BMU 306 is advantageously a single-cell sensing device. In some scenarios, individual S-BMUs may be mounted in or directly on a corresponding battery cell. As such, each S-BMU can be arranged to directly sense the environment and one or more conditions associated with a particular battery cell 402. Of course, the solution is not limited in this regard and in other scenarios a single S-BMU can be configured to acquire data from two or more individual battery cells. As used herein, the term "directly sense" or "directly sensing" as applied to the function of the S-BMU shall mean that the actual sensing or measurement function of a battery related condition is performed by the S-BMU.

The battery data relating to one or more conditions associated with a particular battery cell 402 are collected by an S-BMU 306 and then wirelessly communicated to an M-BMU 304 at the next higher level of the network hierarchy. According to one aspect, each M-BMU 304 will collect battery cell data communicated from the plurality of S-BMU 306 that are associated with a particular battery module 404. As shown in FIG. 4, A battery module 404 consists of multiple cells 402 connected in series and/or parallel, usually encased in a mechanical structure.

In addition to its role as a data collection node, each M-BMU 304 is also a multi-cell sensing device that is independently wired to the battery module 404. As explained below in further detail, each M-BMU 304 is configured to directly sense the individual status of a plurality of battery cells 402 associated with a battery module 404. As used herein, the term "directly sense" or "directly sensing" as applied to the operations of the M-BMU shall mean that the actual sensing or measurement function of a battery related condition is performed by the M-BMU. In this regard M-BMU 304 will independently directly acquire measurement data for one or more conditions associated with each of the individual battery cells 402 that together make up a particular battery module 404. Because this data is acquired directly by the M-BMU separately from the data that is directly acquired by each S-BMU, the two data sets are independent.

In some scenarios, the M-BMU can compare the data it collects directly from the battery module 404 with the data collected by each of the S-BMUs. For example, such a comparison may be useful in some scenarios to evaluate whether each battery cell is operating safely. Further, the M-BMU can in some scenarios calculate for each battery cell a State of Charge (SoC) and/or a State of Health (SoH) of the battery. The SoH is a figure of merit of the condition of a cell compared to its ideal condition. SoC is sometimes defined as the available capacity (in Amp-hours) expressed as a percentage of the rated capacity of the cell.

One or more of the SoH, the SoC, and the battery data acquired by the S-BMU and/or the M-BMU can be transmitted wirelessly to the T-BMU. In some scenarios, the T-BMU can perform calculations based on the raw data from the S-BMU and/or M-BMU to independently determine SoC and SoH metrics for each cell 402. Further, the T-BMU can compare the SoC and/or SoH values that it calculates to the SoC and/or SoH values which are calculated at the M-BMU nodes. Consequently, the T-BMU can independently evaluate the condition of each battery cell, and cross-check its results with the results obtained at the M-BMU level. If significant differences are determined between the values calculated by the M-BMU and the T-BMU then a fault condition signal can be generated by the T-BMU.

In the BMS solution described herein the sensing device of the M-BMUs operates completely independent of the sensing device of the S-BMU - separate input terminals, supplies, and reference voltage generations. Consequently, the likelihood of a single point failure is greatly reduced. The WiBaAN provides a BMS with high flexibility, highly reliability and secure wireless network communications facilitated by the first wireless network and the second wireless network. Accordingly, success of the redundant sensing is ensured.

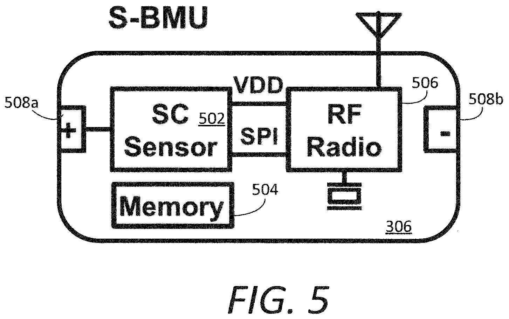

FIG. 5 shows a block diagram of an S-BMU 306. The S-BMU can comprise a single cell (SC) sensor 502, a data store or memory 504, and a wireless radio transceiver 506 in communication with the sensor. Input terminals 508a, 508b can be used to facilitate a wired connection of the S-BMU to a battery cell for the sensing described herein. In some scenarios, the nonvolatile memory 504 can be used to store the cell identification and the vital operating state and history (for example, over-voltage (OV), under-voltage (UV), over-temperature (OT), or the number of charge/discharge cycles).

Single battery cell sensing circuits are well-known in the art and therefore SC sensor 502 will not be described here in detail. However, it will be appreciated that the SC sensor 502 can be configured to measure various conditions associate with an individual battery cell such as the cell's voltage, current and temperature. As such, the SC sensor 402 can comprise power management circuits, analog switching circuitry, measurement signal conditioning circuitry coupled to the analog switching circuitry, and at least one analog to digital converter (ADC). The SC sensor 402 can also include a processing element to control the operation of the S-BMU. For example, the processing element can be comprised of a microcontroller, an application specific circuit, a programmable logic device, other type of electronic circuit programmed to perform the functions described herein. These components are omitted in FIG. 5 to facilitate greater clarity in understanding the solution.

The sensing data acquired by the SC sensor 502 can be transmitted to the upper-level M-BMU via wire harness, but in order to enhance flexibility and convenience of a BMS disclosed herein, the measurement data is advantageously communicated wirelessly to the M-BMU using the wireless radio transceiver 506. In some scenarios, the S-BMU 306 can be used to facilitate a passive cell balancing function. However, so as to minimize any potential thermal issues, it can be advantageous to exclude such passive cell balancing functions from the S-BMU.

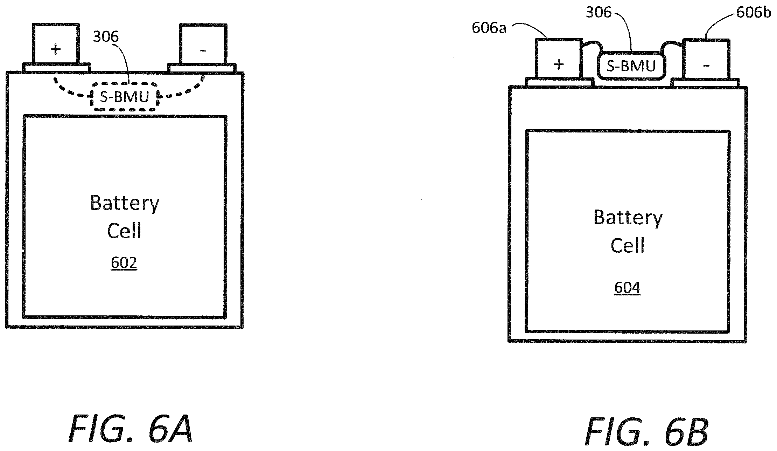

Shown in FIGs. 6A and 6B are two different implementations of an S-BMU in a BMS described herein. FIG. 6A depicts a sensor-in-battery (SIB) structure that combines an S-BMU inside a battery cell 602. Such an arrangement usually involves a backend process whereby the S-BMU is incorporated in the battery cell as part of a battery cell manufacturing process. This structure inherently provides stable wire connection between a battery cell and sensor. The length of the connection wire is short and the wire harness is not exposed to the outside, so measurement error can be reduced. The SIB-type S-BMU is very useful for the secondary use of battery cells because it can integrate the information of the charge/discharge and usage history of the battery cell with a unique identification of the battery cell. As an alternative, a sensor-on-battery (SOB) structure in FIG. 6B shows a cell mounting method in which an S-BMU is disposed on the battery cell 604, connected to the cell terminals 606a, 606b external of the cell housing.

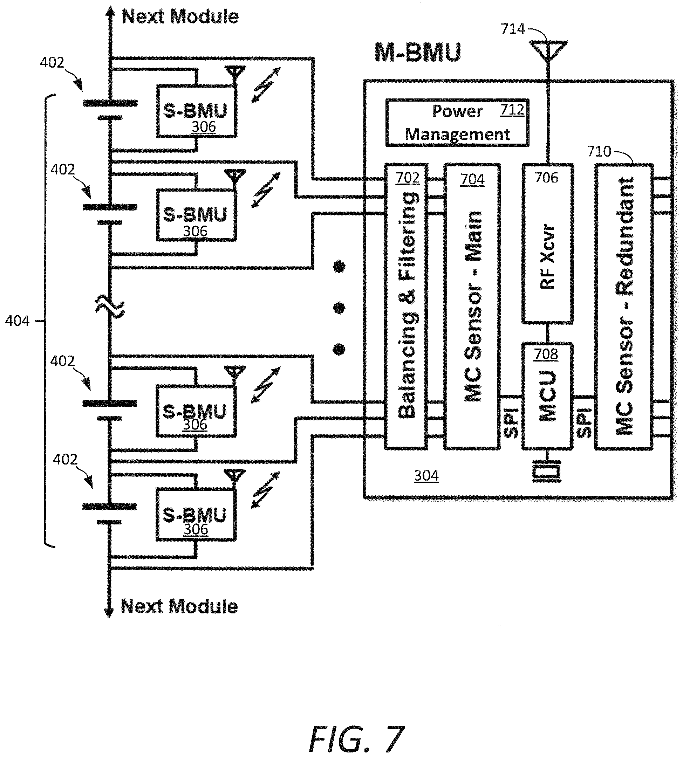

FIG. 7 illustrates certain additional details relating to the configuration of the S-BMU 306 and an M-BMU 304 in the BMS of FIG. 4. Redundant sensing is facilitated in this scenario using the S-BMUs mounted on individual battery cells 402 and with the M-BMU, where wired sensing connections of the M-BMU are connected to the power taps of the cells 402 comprising a particular battery module 404. The cell sensing operations (e.g., current, voltage, and temperature) can proceed concurrently in a plurality of S-BMUs 306 and M-BMUs 304 according to a command received by the M-BMU from the T-BMU. The raw sensing data is first stored in each S-BMU 306 and is then transmitted to the M-BMU by the predetermined wireless communication method at the designated time.

According to one aspect, each M-BMU 304 can compare its own sensing data to the data transmitted from the S-BMUs for a particular battery module 404. This data can be used to determine whether the battery cells 402 and/or the S-BMU 306 are experiencing a fault condition. In FIG. 7 it may be noted that the electrical connecting points where the S-BMU is connected to the battery cell, are different from the connecting points where the M-BMU is connected to the battery cell. Therefore, the two types of sensing devices (S-BMU and M-BMU) will have independent inputs from each other. The data of the S-BMU may be transmitted to the M-BMU via wire communications. However, considering the flexibility of the architecture and the convenience of assembly, it is advantageous to use wireless communication for this purpose.

All the power taps of the cells in one battery module 404 are wired to the M-BMU 304 associated with that battery module. These direct wired connections can facilitate direct measurement of cell voltage, temperature and current. An added advantage of this arrangement is that the M-BMU can perform charge balancing for the cells associated with a particular battery module 404. Cell balancing ensures that each cell in a battery module maintained at a healthy battery state of charge (SoC), thereby preventing damage due to excessive discharging or overcharging. Passive balancing simply dissipates excess charge in a bleed resistor, whereas active cell balancing redistributes charge between battery cells during the charge and discharge cycles. Cell balancing techniques are well-known in the art and therefore will not be described here in detail. Charge balancing performed at the M-BMU avoids excess heat buildup which might otherwise occur if the charge balancing was performed by the S-BMU at each cell.

In the M-BMU 304 the inputs from the battery cells are processed in a charge balancing and low-pass filtering block 702. The inputs are then measured in a multi-cell sensing device 704. These measurements can include voltage, current and/or temperature. This data is then transmitted to a T-BMU using wireless transceiver 706 under the control of a master control unit 708. The wireless RF transceiver 706 communicates the data to a higher-level T-BMU node. In order to increase the degree of redundant sensing, an additional multi-cell sensing device 710 can be added to the M-BMU circuit board as shown in FIG. 1. Such a redundant sensing scheme could be similar to a conventional redundant sensing methodology described herein with respect to FIG. 1. Power management within the M-BMU is handled by a power management unit 712.

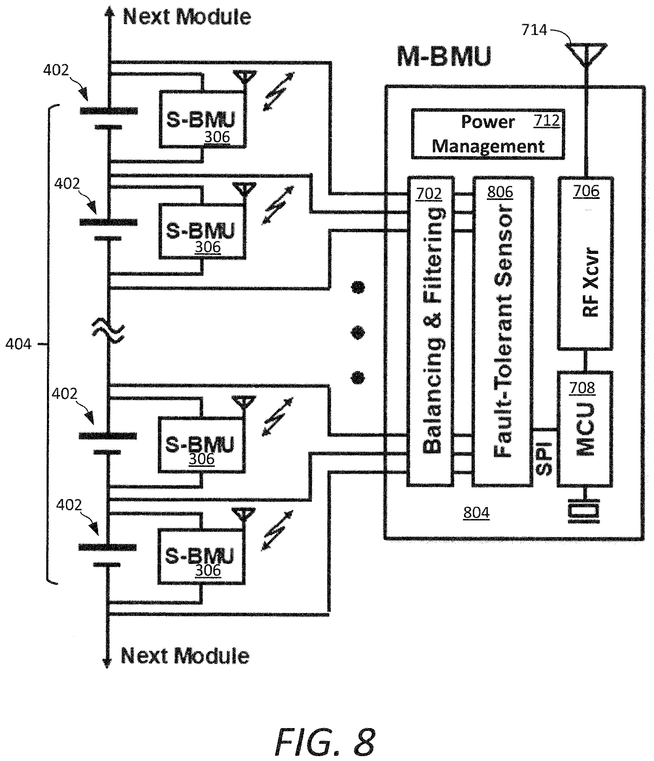

The M-BMU 804 shown in FIG. 8 is similar to the M-BMU 304 shown in FIG. 7. However, rather than using redundant multi-cell sensing devices, the M-BMU in FIG. 8 uses a fault-tolerant sensor 806. The fault-tolerant sensor 806 can in some scenarios comprise a sensing system on a chip or SoC. For example, the fault-tolerant sensor 806 can be similar to the fault tolerant battery sensing system 200 described herein with respect to FIG. 2.

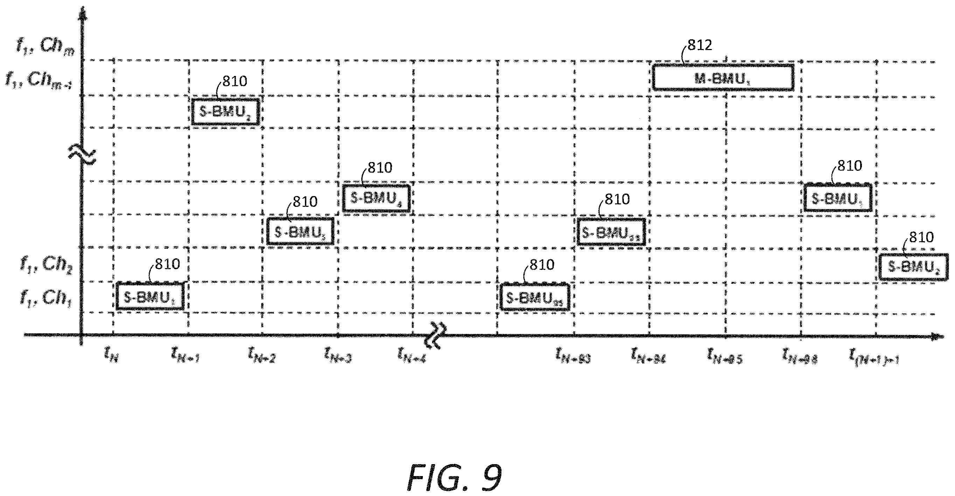

The M-BMUs in FIGs. 7 and 8 are shown as including only a single wireless RF transceiver 707 and a single antenna 714 for wireless communication. Accordingly, the solution disclosed herein can in some scenarios make use of time division multiplexing to avoid communication conflicts between the first and the second wireless communication network. For example, FIG. 9 shows that the S-BMU data packets 810 with relatively short packet length communicate with the M-BMU sequentially on frequency band *f*₁, and various frequency channels Ch*₁*, Ch*₂*, ... Ch*ₘ*. during a series of time slots. Thereafter, a longer M-BMU data packet 812 is used to communicate with the T-BMU.

The frequency band and channel to be used and the modulation type for the wireless communication described herein are determined in advance, or dynamically changed based on the communication circumstances. The second wireless networks between each M-BMU and the S-BMU associated with a particular battery module) feature a relatively short transmission distance. Accordingly, these second wireless networks can take utilize a relatively simple network architecture, short in data length and may be somewhat isolated electrically by the battery module jackets. A simple and low-power communication scheme, such as Amplitude Shift Keying (ASK), can be used in such scenarios. Of course, ASK is merely one possible keying technique and the solution is not intended to be limited in this regard. On the other hand, for purposes of implementing the first wireless network between the M-BMU and the T-BMU, various additional factors must be considered. These factors can include the communication distance, the amount of data to be communicated, the complexity of the internal structure of the battery pack, and the avoidance of external interference. Taking these factors into consideration, it can be advantageous to use a more complex and reliable wireless communication scheme for the first wireless network.

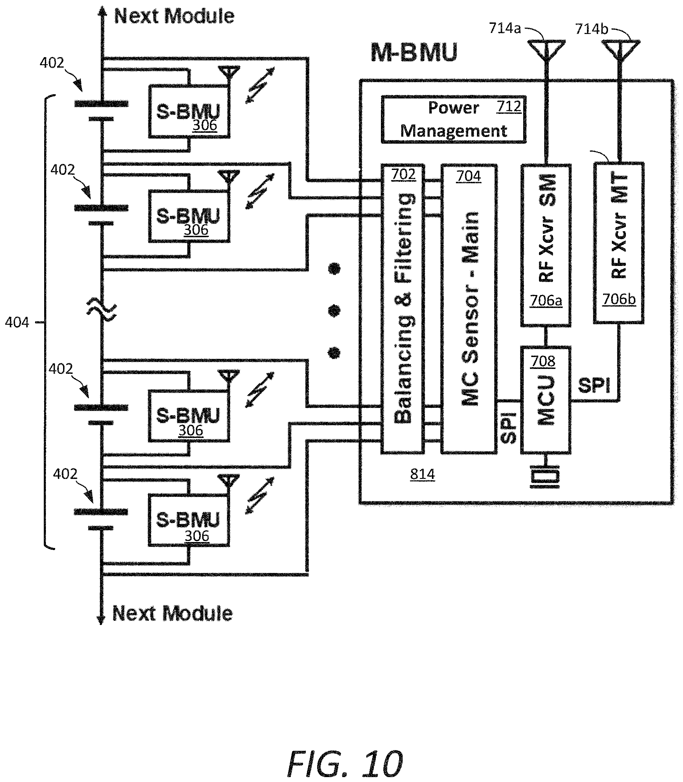

To ensure greater reliability, separate radio hardware can be used to implement the first and second wireless networks. For example, an M-BMU 814 shown in FIG. 10 is similar to the M-BMU 304 shown in FIG. 8. However, rather than using a single wireless RF transceiver 706 as shown in FIGs. 7 and 8, the system in FIG. 10 utilizes dual wireless RF transceivers 706a, 706b with antennas 714a, 714b. Such a dual transceiver configuration can be used to facilitate frequency division multiplexing whereby the M-BMU 814 can concurrently communicate on different frequency bands at the same time. This can facilitate more efficient use of time resources and can allow reading the data of the whole battery module 404 in a shorter time.

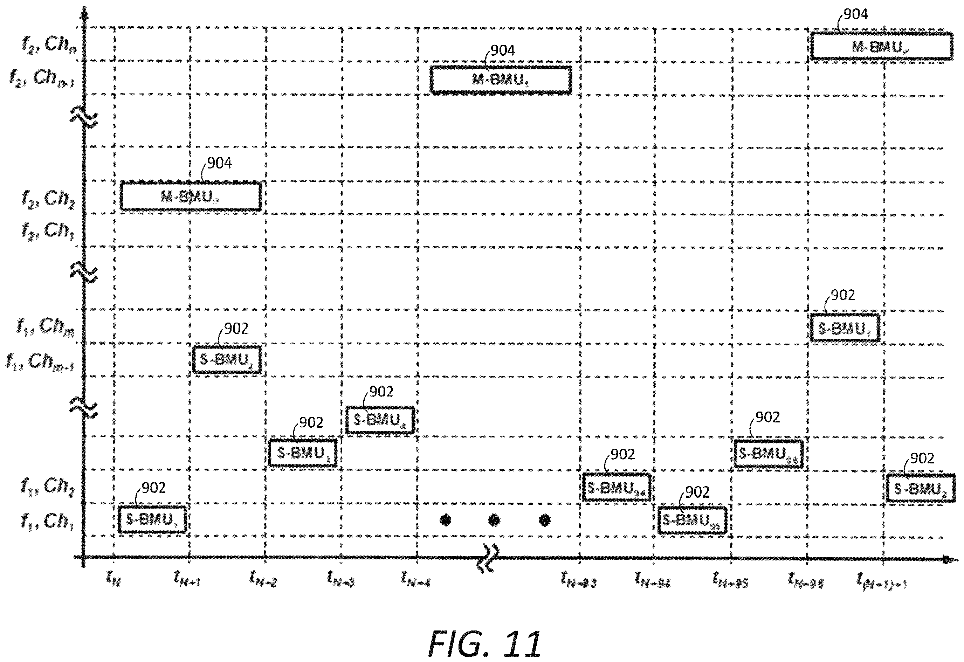

FIG. 11 shows that the S-BMU data packets 902 with relatively short packet length are communicated to the M-BMU sequentially on frequency band *f*₁, and various frequency channels Ch*₁*, Ch*₂*, ... Ch*ₘ*. during a series of time slots. Concurrently longer M-BMU data packets 904 are used by the M-BMU to communicate with the T-BMU on frequency band *f*₂, and various frequency channels Ch*₁*, Ch*₂*, ... Ch*ₘ*. during a series of overlapping time slots. So the M-BMU can communicate with the S-BMU concurrently with its communications with the T-BMU.

In the various BMS implementations described herein, a complete failure of a wireless transceiver (e.g., RF transceiver 706) in an M-BMU could potentially cause an interruption in the monitoring and balancing operations for a particular battery module. This is due to the fact that the M-BMU serves as a central data collection and data forwarding node for each S-BMU within a particular battery module. To facilitate a further level of safety and protection, such potential interruptions can be avoided by causing the S-BMU in each module to communicate directly with the T-BMU under certain conditions. For example, consider a scenario involving a failure in an M-BMU 304 which prevents the M-BMU for a particular battery module from communicating with the T-BMU 302. Under such conditions, each S-BMU within such battery module can revert to a safety mode in which such S-BMUs will wirelessly communicate directly with a T-BMU.

To facilitate such capability, the RF transceiver 414 in the T-BMU can be configured to periodically communicate with the S-BMU in accordance with a wireless protocol that is normally used by the S-BMU to communicate with the M-BMU. Alternatively, the S-BMU can be configured to communicate with the T-BMU in accordance with the wireless protocol that is normally used by the T-BMU to communicate with the M-BMU. This would represent a failsafe mode to ensure that data for cells 402 in a particular battery module 404 are reported to the T-BMU 302 in the absence of an operational M-BMU for that battery module. The failsafe communication mode could be initiated by the T-BMU when it detects a problem with the S-BMU and/or the S-BMU detects a communication problem with the M-BMU. As a further alternative, an M-BMU that detects a failure could alert that T-BMU and/or M-BMU that they need to communicate in accordance with the failsafe mode described herein.

The described features, advantages and characteristics disclosed herein may be combined in any suitable manner. One skilled in the relevant art will recognize, in light of the description herein, that the disclosed systems and/or methods can be practiced without one or more of the specific features. In other instances, additional features and advantages may be recognized in certain scenarios that may not be present in all instances.

As used in this document, the singular form "a", "an", and "the" include plural references unless the context clearly dictates otherwise. Unless defined otherwise, all technical and scientific terms used herein have the same meanings as commonly understood by one of ordinary skill in the art. As used in this document, the term "comprising" means "including, but not limited to".

Various aspects of sample embodiments according to the present disclosure may be appreciated from the following enumerated example embodiments (EEEs):
EEE 1: A battery management system (BMS), comprising: a plurality of master battery management units (M-BMU), each M-BMU comprising at least one multi cell battery sensing device configured to directly sense at least one condition of each battery cell of a plurality of battery cells associated with one of a plurality of battery modules in a battery pack; a plurality of sensor battery management units (S-BMU) associated with each of the battery modules, each S-BMU comprising a single-cell battery sensing device and configured to directly sense at least one condition of associated with a particular battery cell; and each of the plurality of S-BMU associated with a particular battery module configured to wirelessly communicate data acquired as a result of the direct sensing by the S-BMU, to one of the plurality of M-BMU associated with the particular battery module.
EEE 2: The BMS of EEE 1, wherein the S-BMU and the M-BMU are configured to directly sense one or more the same conditions.
EEE 3: The BMS of EEE 2, wherein the data acquired as a result of the direct sensing by the M-BMU is redundant as compared to the data acquired as a result of the direct sensing by the S-BMU.
EEE 4: The BMS of EEE 2 or EEE 3, wherein the M-BMU is configured to compare for each battery cell the data acquired as a result of the direct sensing by the M-BMU and the data acquired as a result of the direct sensing by the S-BMU.
EEE 5: The BMS of any of EEEs 1-4, wherein the M-BMU is configured to use at least one of the data provided by the plurality of S-BMU and the data directly acquired by the M-BMU, to determine for each battery cell associated with the battery module a battery state selected from the group consisting of a state of charge (SoC) and a state of health (SoH).
EEE 6: The BMS of EEE 5, wherein the M-BMU is configured to wirelessly communicate at least one of the SoC and SoH of each battery cell associated with a particular battery module to a top-level battery management unit (T-BMU).
EEE 7: The BMS of EEE 6, wherein the M-BMU is configured to communicate with the plurality of S-BMU in accordance with a first wireless communication protocol, and communicates with the T-BMU in accordance with a second wireless communication protocol, and the first wireless communication protocol is different from the second wireless communication protocol.
EEE 8: The BMS of EEE 6 or EEE 7, wherein each of the M-BMU comprises a first wireless transceiver to facilitate the wireless communications with the plurality of S-BMU associated with a battery module, and a second wireless transceiver to facilitate the wireless communications with the T-BMU.
EEE 9: The BMS of any of EEEs 1-8, wherein the M-BMU is configured to wirelessly communicate to a top-level battery management unit (T-BMU) one or more data types selected from the group consisting of (a) raw data acquired as a result of the direct sensing by the M-BMU, (b) raw data acquired as a result of the direct sensing by the S-BMU, (c) State of Charge (SoC) data determined for each battery cell associated with the battery module, and (d) State of Health (SoH) data determined for each battery cell associated with the battery module.
EEE 10: The BMS of EEE 9, wherein the T-BMU is configured to compare at least one of the SoC data and the SoH data provided by the M-BMU to at least one of independently determined SoC and SoH data estimated by the T-BMU based on at least one of the raw data acquired as a result of the direct sensing by the M-BMU and the raw data acquired as a result of the direct sensing by the S-BMU.
EEE 11: The BMS of any of EEEs 1-10, wherein the M-BMU is configured to facilitate the direct sensing of each battery cell of a particular battery module using a plurality of M-BMU wired connections which couple the M-BMU to the battery cell terminals of each battery cell.
EEE 12: The BMS of EEE 11, wherein each of the S-BMU is configured to facilitate the direct sensing of each battery cell using an S-BMU wired connection, and the S-BMU wired connection is physically distinct from the M-BMU wired connection to facilitate an increase in a degree of redundant sensing.
EEE 13: The BMS of any of EEEs 1-12, wherein the plurality of S-BMU are disposed at the battery cell, and have a battery cell mounting configuration selected from the group consisting of an embedded configuration in which the S-BMU is embedded in the battery cell, and an outboard configuration in which the S-BMU is mounted on the battery cell.
EEE 14: The BMS of any of EEEs 1-13, wherein the S-BMU is embedded in the battery cell and comprises a data store containing cell data selected from the group consisting of unique battery cell identification data, over-voltage data, under voltage data, over-temperature and the number of charge/discharge cycles.
EEE 15: The BMS of any of EEEs 1-14, wherein the M-BMU is configured to serve a dual purpose including a first purpose in which it functions as a multi cell battery sensing device which facilitates redundant sensing, and a second purpose in which it functions as an intermediate level data collection node for a plurality a single-cell battery sensing devices.
EEE 16: The BMS of EEE 15, wherein the M-BMU is configured to serve a third purpose comprising a battery cell balancing function.
EEE 17: The BMS of any of EEEs 1-16, wherein the at least one condition is selected from the group consisting of battery cell voltage, battery cell current, and battery cell temperature.
EEE 18: The BMS of any of EEEs 1-17, wherein each of the M-BMU comprise a plurality of multi-cell sensing devices, each configured to facilitate redundant direct sensing of the at least one condition.
EEE 19: The BMS of any of EEEs 1-18, wherein each of the M-BMU comprises a fault-tolerant multi-cell sensing system on a chip.
EEE 20: The BMS of EEE 9 or EEE 10, wherein the S-BMU associated with a particular battery module are configured to wirelessly communicate data acquired as a result of the direct sensing by the S-BMU directly to the T-BMU in the event of a fault in the M-BMU associated with the particular battery module.
EEE 21: A method for redundantly sensing a plurality of batteries in a battery pack, comprising: using at least one multi cell battery sensing device in each of a plurality of master battery management units (M-BMU) to directly sense respectively at least one condition of each battery cell of a plurality of battery cells associated with one of a plurality of battery modules in a battery pack; using a plurality of sensor battery management units (S-BMU), each comprising a single-cell battery sensing device, to individually respectively individually sense directly at least one condition associated with each of a plurality of battery cells associated with each of the battery modules; and wirelessly communicating from each of the plurality of S-BMU associated with a particular battery module, to an M-BMU associated with the particular battery module, data acquired as a result of the individual direct sensing of each battery cell in the particular battery module.
EEE 22: The method of EEE 21, wherein the S-BMU and the M-BMU directly sense one or more the same conditions.
EEE 23: The method of EEE 22, wherein the data acquired as a result of the direct sensing by the M-BMU is redundant as compared to the data acquired as a result of the direct sensing by the S-BMU.
EEE 24: The method of EEE 22 or EEE 23, wherein the M-BMU compares for each battery cell the data acquired as a result of the direct sensing by the M-BMU and the data acquired as a result of the direct sensing by the S-BMU.
EEE 25: The method of any of EEEs 21-24, wherein the M-BMU uses at least one of the data provided by the plurality of S-BMU and the data directly acquired by the M-BMU, to determine for each battery cell associated with the battery module a battery state selected from the group consisting of a state of charge (SoC) and a state of health (SoH).
EEE 26: The method of EEE 25, wherein the M-BMU wirelessly communicates at least one of the SoC and SoH of each battery cell associated with a particular battery module to a top-level battery management unit (T-BMU).
EEE 27: The method of EEE 26, wherein the M-BMU communicates with the plurality of S-BMU in accordance with a first wireless communication protocol, and communicates with the T-BMU in accordance with a second wireless communication protocol, and the first wireless communication protocol is different from the second wireless communication protocol.
EEE 28: The method of EEE 26 or EEE 27, wherein each of the M-BMU uses a first wireless transceiver to facilitate the wireless communications with the plurality of S-BMU associated with a battery module, and uses a second wireless transceiver to facilitate the wireless communications with the T-BMU.
EEE 29: The method of any of EEEs 21-28, wherein the M-BMU wirelessly communicates to a top-level battery management unit (T-BMU) one or more data types selected from the group consisting of (a) raw data acquired as a result of the direct sensing by the M-BMU, (b) raw data acquired as a result of the direct sensing by the S-BMU, (c) State of Charge (SoC) data determined for each battery cell associated with the battery module, and (d) State of Health (SoH) data determined for each battery cell associated with the battery module.
EEE 30: The method of EEE 29, wherein the T-BMU compares at least one of the SoC data and the SoH data provided by the M-BMU, to at least one of independently determined SoC and SoH data estimated by the T-BMU based on at least one of the raw data acquired as a result of the direct sensing by the M-BMU and the raw data acquired as a result of the direct sensing by the S-BMU.
EEE 31: The method of any of EEEs 21-30, wherein the M-BMU facilitates the direct sensing of each battery cell of a particular battery module using a plurality of M-BMU wired connections which couple the M-BMU to the battery cell terminals of each battery cell.
EEE 32: The method of EEE 31, wherein each of the S-BMU facilitates the direct sensing of each battery cell using an S-BMU wired connection, and the S-BMU wired connection is physical distinct from the M-BMU wired connection to facilitate an increase in a degree of redundant sensing.
EEE 33: The method of any of EEEs 21-32, wherein the M-BMU serve a dual purpose including a first purpose in which it functions as a multi cell battery sensing device which facilitates redundant sensing, and a second purpose in which it functions as an intermediate level data collection node for a plurality a single-cell battery sensing devices.
EEE 34: The method of EEE 33, wherein the M-BMU serves a third purpose comprising a battery cell balancing function.
EEE 35: The method of any of EEEs 21-34, wherein the at least one condition is selected from the group consisting of battery cell voltage, battery cell current, and battery cell temperature.
EEE 36: The method of any of EEEs 21-35, wherein each of the M-BMU comprise a plurality of multi-cell sensing devices which facilitate redundant direct sensing of the at least one condition.
EEE 37: The method of any of EEEs 21-36, wherein each of the M-BMU uses a fault-tolerant multi-cell sensing system on a chip to directly sense the at least one condition.
EEE 38: The method of EEE 29 or EEE30, further comprising wirelessly communicating data acquired as a result of the direct sensing by the S-BMU directly from the S-BMU to the T-BMU in the event of a fault in the M-BMU associated with the particular battery module.

Although the systems and methods have been illustrated and described with respect to one or more implementations, equivalent alterations and modifications will occur to others skilled in the art upon the reading and understanding of this specification and the annexed drawings. In addition, while a particular feature may have been disclosed with respect to only one of several implementations, such feature may be combined with one or more other features of the other implementations as may be desired and advantageous for any given or particular application. Thus, the breadth and scope of the disclosure herein should not be limited by any of the above descriptions. Rather, the scope of the invention should be defined in accordance with the following claims and their equivalents.

## Claims

1. A method for redundantly sensing a plurality of batteries in a battery pack, comprising:
using at least one multi cell battery sensing device in each of a plurality of master battery management units (M-BMU) to directly sense respectively at least one condition of each battery cell of a plurality of battery cells associated with one of a plurality of battery modules in a battery pack;
using a plurality of sensor battery management units (S-BMU), each comprising a single-cell battery sensing device, to individually respectively individually sense directly at least one condition associated with each of a plurality of battery cells associated with each of the battery modules; and
wirelessly communicating from each of the plurality of S-BMU associated with a particular battery module, to an M-BMU associated with the particular battery module, data acquired as a result of the individual direct sensing of each battery cell in the particular battery module.

2. The method of claim 1, wherein the S-BMU and the M-BMU directly sense one or more the same conditions.

3. The method of claim 2,
wherein the data acquired as a result of the direct sensing by the M-BMU is redundant as compared to the data acquired as a result of the direct sensing by the S-BMU; and/or
wherein the M-BMU compares for each battery cell the data acquired as a result of the direct sensing by the M-BMU and the data acquired as a result of the direct sensing by the S-BMU.

4. The method of any of claims 1-3, wherein the M-BMU uses at least one of the data provided by the plurality of S-BMU and the data directly acquired by the M-BMU, to determine for each battery cell associated with the battery module a battery state selected from the group consisting of a state of charge (SoC) and a state of health (SoH).

5. The method of claim 4, wherein the M-BMU wirelessly communicates at least one of the SoC and SoH of each battery cell associated with a particular battery module to a top-level battery management unit (T-BMU).

6. The method of claim 5,
wherein the M-BMU communicates with the plurality of S-BMU in accordance with a first wireless communication protocol, and communicates with the T-BMU in accordance with a second wireless communication protocol, and the first wireless communication protocol is different from the second wireless communication protocol; and/or
wherein each of the M-BMU uses a first wireless transceiver to facilitate the wireless communications with the plurality of S-BMU associated with a battery module, and uses a second wireless transceiver to facilitate the wireless communications with the T-BMU.

7. The method of any of claims 1-6, wherein the M-BMU wirelessly communicates to a top-level battery management unit (T-BMU) one or more data types selected from the group consisting of (a) raw data acquired as a result of the direct sensing by the M-BMU, (b) raw data acquired as a result of the direct sensing by the S-BMU, (c) State of Charge (SoC) data determined for each battery cell associated with the battery module, and (d) State of Health (SoH) data determined for each battery cell associated with the battery module.

8. The method of claim 7,
wherein the T-BMU compares at least one of the SoC data and the SoH data provided by the M-BMU, to at least one of independently determined SoC and SoH data estimated by the T-BMU based on at least one of the raw data acquired as a result of the direct sensing by the M-BMU and the raw data acquired as a result of the direct sensing by the S-BMU; and/or
further comprising wirelessly communicating data acquired as a result of the direct sensing by the S-BMU directly from the S-BMU to the T-BMU in the event of a fault in the M-BMU associated with the particular battery module.

9. The method of any of claims 1-8,
wherein the M-BMU facilitates the direct sensing of each battery cell of a particular battery module using a plurality of M-BMU wired connections which couple the M-BMU to the battery cell terminals of each battery cell; and
wherein, in some embodiments, each of the S-BMU facilitates the direct sensing of each battery cell using an S-BMU wired connection, and the S-BMU wired connection is physical distinct from the M-BMU wired connection to facilitate an increase in a degree of redundant sensing.

10. The method of any of claims 1-9,
wherein the M-BMU serve a dual purpose including a first purpose in which it functions as a multi cell battery sensing device which facilitates redundant sensing, and a second purpose in which it functions as an intermediate level data collection node for a plurality a single-cell battery sensing devices; and
wherein, in some embodiments, the M-BMU serves a third purpose comprising a battery cell balancing function.

11. The method of any of claims 1-10,
wherein each of the M-BMU comprise a plurality of multi-cell sensing devices which facilitate redundant direct sensing of the at least one condition; and/or
wherein each of the M-BMU uses a fault-tolerant multi-cell sensing system on a chip to directly sense the at least one condition.

12. A battery management system (BMS), comprising:
a plurality of master battery management units (M-BMU), each M-BMU comprising at least one multi cell battery sensing device configured to directly sense at least one condition of each battery cell of a plurality of battery cells associated with one of a plurality of battery modules in a battery pack;
a plurality of sensor battery management units (S-BMU) associated with each of the battery modules, each S-BMU comprising a single-cell battery sensing device and configured to directly sense at least one condition of associated with a particular battery cell; and
each of the plurality of S-BMU associated with a particular battery module configured to wirelessly communicate data acquired as a result of the direct sensing by the S-BMU, to one of the plurality of M-BMU associated with the particular battery module.

13. The BMS of claim 12,
wherein the plurality of S-BMU are disposed at the battery cell, and have a battery cell mounting configuration selected from the group consisting of an embedded configuration in which the S-BMU is embedded in the battery cell, and an outboard configuration in which the S-BMU is mounted on the battery cell; and/or
wherein the S-BMU is embedded in the battery cell and comprises a data store containing cell data selected from the group consisting of unique battery cell identification data, over-voltage data, under voltage data, over-temperature and the number of charge/discharge cycles.

14. The BMS of claim 12 or claim 13, configured to perform operations comprising the operations recited in any of claims 1-11.

15. The method of any of claims 1-11 or the BMS of claims 12 or claim 13, wherein the at least one condition is selected from the group consisting of battery cell voltage, battery cell current, and battery cell temperature.
